# EUROPEAN PATENT APPLICATION

(11) **EP 2 493 003 A1**
(43) Date of publication of application: **29.08.2012**
(21) Application number: 12000129.2
(22) Date of filing: 11.01.2012
(51) Int. Cl.: H01M 10/42, H01M 10/48, G01R 19/165, G01R 31/36, G01R 31/40, H01M 6/42

(54) **Storage battery system and storage battery module**

(30) Priority: 28.02.2011 JP 2011041092
(71) Applicant: HITACHI, LTD., Tokyo 100-8280 (JP)
(72) Inventor: Takeuchi, Takashi, Tokyo 100-8220 (JP); Terada, Takahide, Tokyo 100-8220 (JP); Osada, Kenichi, Tokyo 100-8220 (JP)
(74) Representative: Strehl Schübel-Hopf & Partner

(57) **Abstract**

A storage battery system in which multiple storage battery modules are connected in series and such that deteriorated storage battery modules may be made replaceable without causing dielectric breakdown. The storage battery system is one that has multiple storage battery modules connected in series and has a mechanism of, when the storage battery module is detached, disconnecting power source line connected to the storage battery modules after disconnecting communication line connected to the storage battery modules.

## Description

### FIELD OF THE INVENTION

The present invention relates to a storage battery module and a storage battery system that includes multiple storage battery modules.

### BACKGROUND OF THE INVENTION

Let multiple electric cells (for example, Li-ion cell) connected in series be a storage battery module. There is considered a storage battery system for obtaining a high output voltage by connecting in series multiple storage battery modules of this each as a unit to obtain a high voltage.

However, when individual storage battery modules start to produce variations in voltage and charge/discharge capacity due to aging etc., the charge/discharge capacities that these storage battery modules bear become uneven, which will result in lowering of performance as an overall system. The reason is that since the storage battery modules are connected in series, if the charge/discharge capacity variation of the storage battery modules therein becomes large, a discharge capability is restrained by the module having a small capacity at the time of discharge, and the module whose remaining power is large becomes full charged and thereby the charging beyond that are not performed; therefore, the charge/discharge capability of the overall system will lower.

Therefore, there is disclosed a technology where a module control unit is arranged to each storage battery module and suppresses the variation by monitoring and controlling a state of the storage battery module (Japanese Unexamined Patent Application Publication No. 2008-289234). Since the module control units are connected in series via the singe battery under monitoring, for signal transmission, the module control units are connected in the form of a daisy chain to perform information transmission.

### SUMMARY OF THE INVENTION

In recent years, in view of reduction of global warming gases and saving of resource consumption, electric vehicles, such as an HEV (Hybrid Electric Vehicle) and an EV (Electric Vehicle) attract many attentions. Direct current power sources used in these vehicles require high output voltages, and for that purpose, multiple electric cells are connected in series and are used. Among such direct power sources, a storage battery system using a Li-ion secondary battery attracts attention especially because of its high energy density. On the other hand, from consideration of safety, the storage battery that is small in size and is capable of obtaining a high output like this is required to control charge/discharge states of each electric cell with high accuracy. Moreover, since the storage battery systems as described above is assumed to be used for a long time in various environments, they must maintain high reliability.

Moreover, since in these storage battery modules, storage battery deterioration advances unfailingly in connection with operation in systems, a measure against deteriorated modules becomes an important problem in a long-term operation of the storage battery system. In order to maintain system performance and to enable its long-term operation, the present invention provides a storage battery module that enables the deteriorated storage battery module to be replaced safely without causing dielectric breakdown and a storage battery system.

In order to address the problem of this invention, in the storage battery system that has multiple storage battery modules connected in series, there are provided power source line for connecting power source terminals of multiple storage battery modules, communication line for connecting communication terminals of the multiple storage battery modules, and a mechanism of, when a first storage module is detached from the multiple storage modules, disconnecting the power source line connected to the first storage battery module after disconnecting the communication line connected to the first storage battery module.

Thereby, the deteriorated storage battery module can be replaced safely without causing the dielectric breakdown.

### BRIEF DESCRIPTION OF THE DRAWINGS

Fig. 1 is a diagram showing a storage battery system;
Fig. 2 is a diagram for explaining a problem of the present invention;
Fig. 3 is a block diagram of a storage battery module according to a first embodiment;
Fig. 4 is a diagram showing a replacement flow of the storage battery module;
Fig. 5 is a diagram showing a situation of Step S08 in the replacement flow of Fig. 4;
Fig. 6 is a diagram showing a situation of Step S14 in the replacement flow of Fig. 3;
Fig. 7 is a modification of the replacement flow of Fig. 4;
Fig. 8 is a diagram of a modification of the storage battery module according to the first embodiment;
Fig. 9 shows an appearance of a storage battery module according to a second embodiment;
Fig. 10 is a sectional view of the storage battery module according to the second embodiment; and
Fig. 11 is a diagram showing a state where the storage battery modules according to the second embodiment are connected together in a battery rack.

### DETAILED DESCRIPTION OF THE PREFERRED EMBODIMENTS

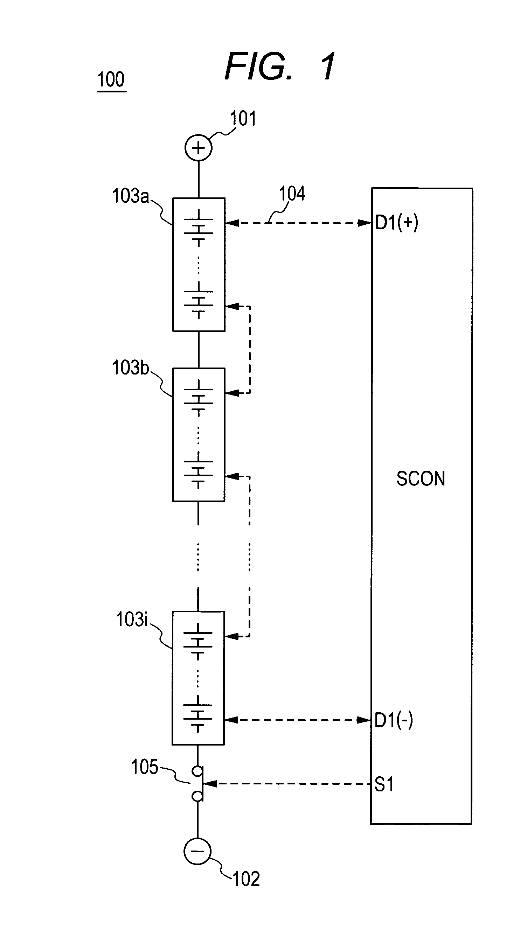

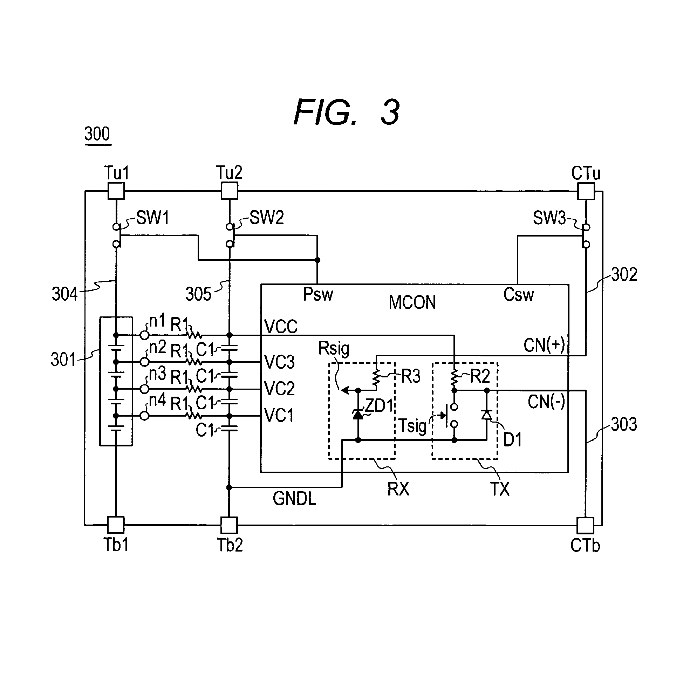

Fig. 1 is a storage battery system of the present invention. A storage battery module 103 is a minimum replacement unit of the storage battery system. An internal configuration will be explained in detail using Fig. 3 etc. A storage battery system 100 includes multiple storage battery modules, and a column of the storage battery modules 103a to 103i are connected in series in an example of Fig. 1. A terminal 101 (positive electrode) and a terminal 102 (negative electrode) are output terminals of the storage battery system, and a load driven by the storage battery system is connected between these terminals.

A control unit SCON is a control device for monitoring a current outputted by the storage battery system 100 and controlling a state of each storage battery module according to the amount of output current etc. For that purpose, the control unit SCON has communication line that connects the storage battery modules in the form of a daisy chain in order to perform communication with the modules. In the present invention, the control unit SCON further performs a control for replacement of the storage battery modules.

In the example of Fig. 1, communication line 104 is provided between the communication terminals D1(₊) and D1(₋) and communication between the control unit SCON and the storage battery modules 103a to 103i is performed with the communication line 104 connected in the form of the daisy chain.

Incidentally, the communication line 104 may be configured as a path of mono-directional communication from a positive electrode side communication terminal D(+) to a negative electrode side communication terminal D(-) (or a path of mono-directional communication from the negative electrode side communication terminal D (-) to the positive electrode side communication terminal D(+)). Alternatively, the communication line 104 can also be configured as a path of bidirectional communication between the positive electrode side communication terminal D(+) and the negative electrode side communication terminal D(-). A role of a switch 105 will be described later.

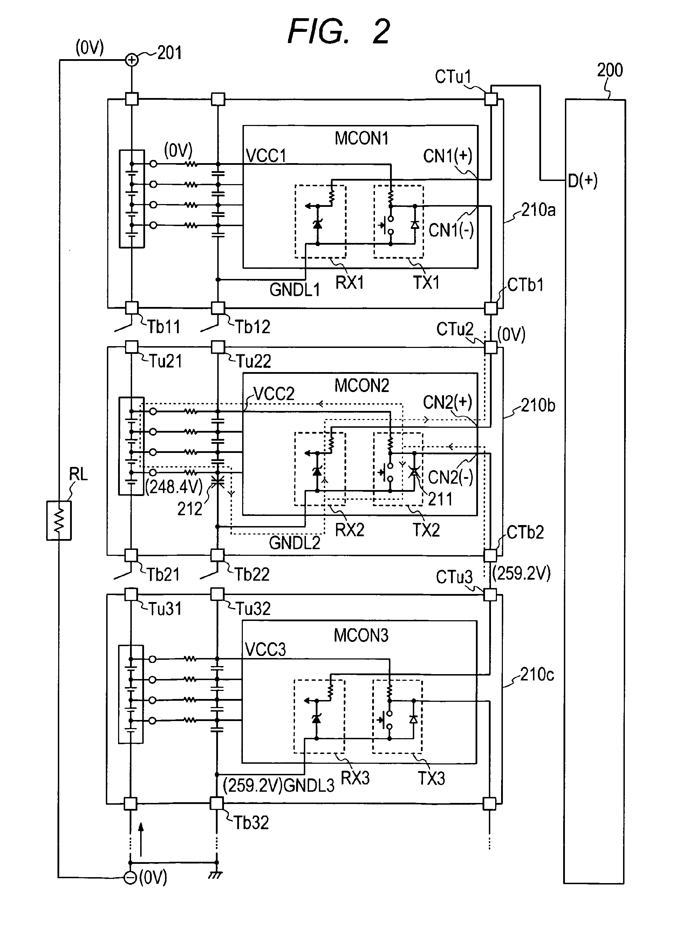

In the storage battery system of Fig. 1, the inventors have noticed that when one deteriorated storage battery module is intended to be replaced, there is a possibility that dielectric breakdown may destroy an element constituting the storage battery module with a high voltage produced during the replacement. The problem of the present invention will be explained using an example of Fig. 2 where the storage battery system is constructed with storage battery modules 210 of a general configuration. The example of Fig. 2 is the storage battery system of rated voltage 302.4 V. 21 storage battery modules in each of which four electric cells each of 3.6 V (notated by a battery symbol) are connected in series are connected in series. Moreover, as was explained in Fig. 1, the communication line wherewith the serially connected storage battery modules communicate with a control unit 200 is connected therebetween in the form of the daisy chain.

Here. let it be assumed that when a storage battery module 210b is detached, electrical connections of power source terminals Tb11, Tb12 of a module 210a, power source terminals Tu21, Tu22 of the module 210b, power source terminals Tu31, Tu32 of a module 210c, and power source terminals Tb21, Tb22 of the module 210b are separated, and on the other hand, electrical connections of a communication terminal CTb1 of the module 210a, communication terminals CTu2, CTb2 of the module 210b, and a communication terminal CTu3 of the module 210c are maintained in the form of the daisy chain. Fig. 2 shows this state.

The potential of a positive electrode 201 is set to 0 V by separating the power source terminal and making them perform discharge through the load RL. Therefore, a power supply potential VCC1 of a module controller MCON1 of the module 210a becomes 0 V, and this potential appears on the communication terminal CTb1. Since the communication terminal CTb1 and the communication terminal CTu2 of the module 210b are electrically connected, a potential of the communication terminal CTu2 also becomes 0 V. On the other hand, since 18 modules, i.e., 72 electric cells connected in series, are connected on the negative electrode side away from the module 210c, a local reference potential GNDL3 of a power source terminal Tb32 of the module 210c and a module controller MCON3 becomes 259.2 V (= 72 x 3.6 V). For this reason, if a portion of the voltage drop caused by the element of the module controller MCON3 is disregarded, a potential of 259.2 V will appear on the communication terminal CTb2 of the module 210b.

As a result, by making a forward current flow through a Zener diode of a receiver circuit RX2 and letting discharge occur to the communication terminal CTu2, a local reference potential GNDL2 of a module controller MCON2 of the module 210b becomes about 0 V. Accordingly, a potential of 248.4 V that is a potential 259.2 V dropped by a voltage equal to three electric cells in series (10.8 V) is applied to one terminal of a capacitor 212, and a potential of about 0 V is applied to the other terminal. Similarly, a reverse voltage of about 259.2 V is applied to a diode of a transmitter circuit TX2. Since an internal element has a withstand voltage a few times larger than that of the module, application of a large voltage like this may result in occurrence of the dielectric breakdown of the element.

### First Embodiment

A first embodiment will be described. In the first embodiment, the storage battery system is constructed with storage battery modules each having a switch in it. Fig. 3 is a block diagram showing a principal configuration of a storage battery module 300. This is used as the storage battery module of the storage battery system of Fig. 1. The storage battery module has a column of electric cells 301 connected in series, a module controller MCON, and a switch SW for interrupting connection between an external terminal of the module and the internal element. The electric cell 301 is a secondary battery like a Li-ion cell, for example. The module controller MCON acquires information of a voltage, a current, temperature, etc. of the electric cell, and communicates with the control unit SCON by communication line 302 and communication line 303 connected with other modules in daisy chain. This example shows a transmitter circuit TX and a receiver circuit RX for performing the mono-directional communication with the control unit SCON. The receiver circuit RX receives a signal Rsig from a positive electrode side communication terminal CTu of the system, and the transmitter circuit TX modulates a signal Tsig and outputs it to a negative electrode side communication terminal CTb of the system. When performing the bidirectional communication, it can be realized by providing another pair of communication terminals, and providing a receiver circuit for receiving a signal from a negative electrode side communication terminal of the system and a transmitter circuit for transmitting a signal from a positive electrode side communication terminal of the system. As a communication method between the storage battery modules, well-known standards (for example, CAN, LIN, UART, etc.) are applicable.

Moreover, the module controller MCON obtains the power source VCC and the local reference potential GNDL from the electric cell column 301. The module controller MCON is monitoring the output voltages (VC1 to VC3, and VCC) of electric cells by monitoring potentials n1 to n4 among the electric cells. For example, when an instruction to lower the output voltage of the storage battery module 300 is received from the system control unit SCON, the module controller MCON can specify an electric cell with a high output voltage, and can regulate the output voltage of the electric cell by making the battery flow a current in a pertinent resistance R1 and thereby consuming electric power thereof.

Switches SW1 to SW3 are for connecting/disconnecting a power source line 304, a monitor line 305, and the communication lines 302, 303 of the storage battery module, respectively. The module controller MCON generates a power source control signal Psw and a communication control signal Csw; the switches SW1, SW2 are controlled by the power source control signal Psw, and the switch SW3 is controlled by the communication control signal Csw. In Fig. 3, although the switches are mounted on the negative electrode side of the storage battery module, these can also be mounted on the negative electrode side, or on both sides of the positive and negative electrodes.

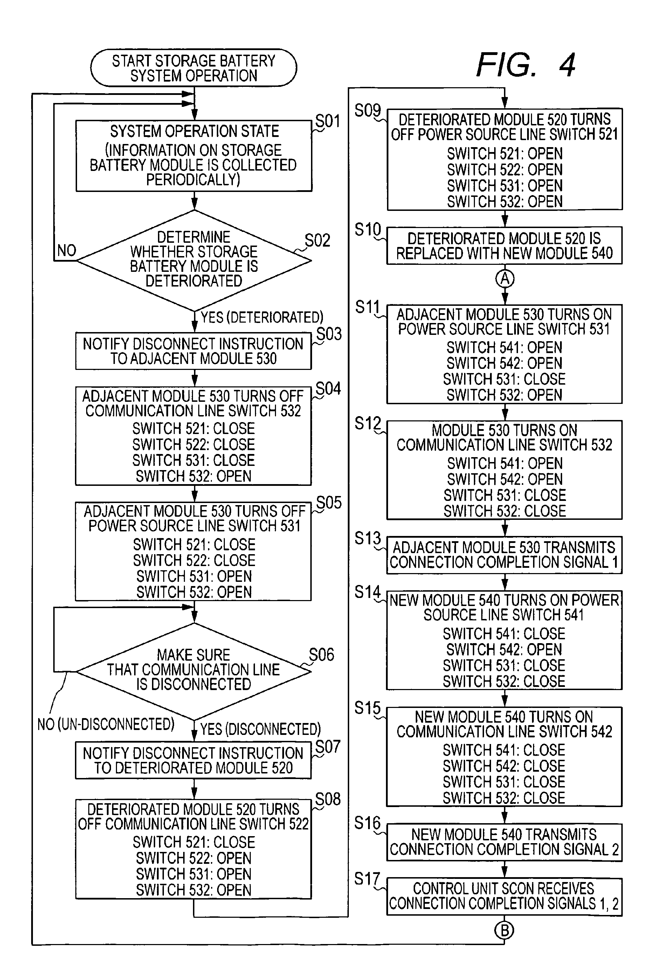

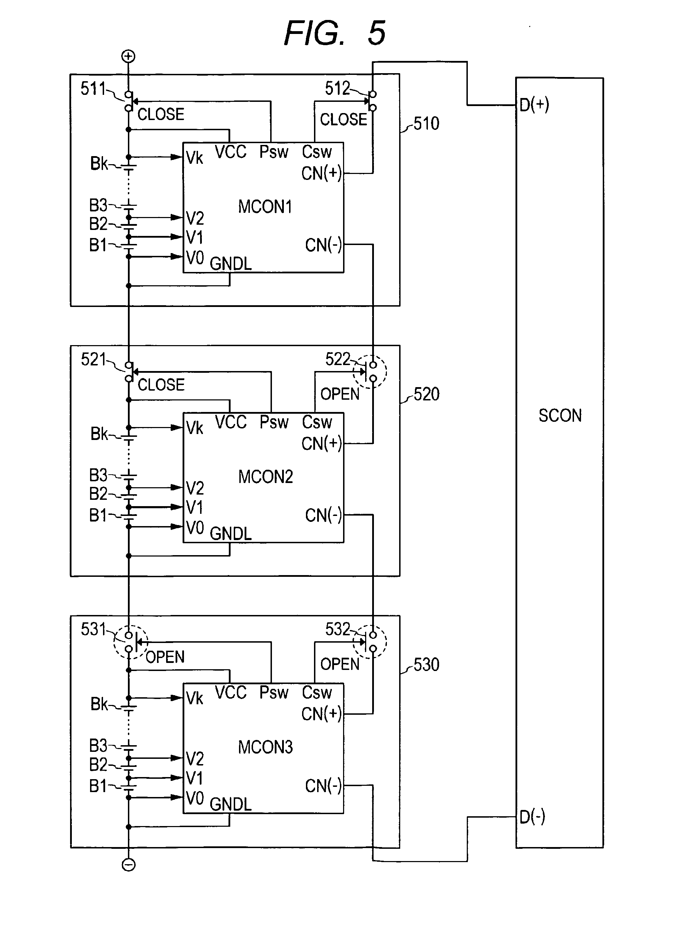

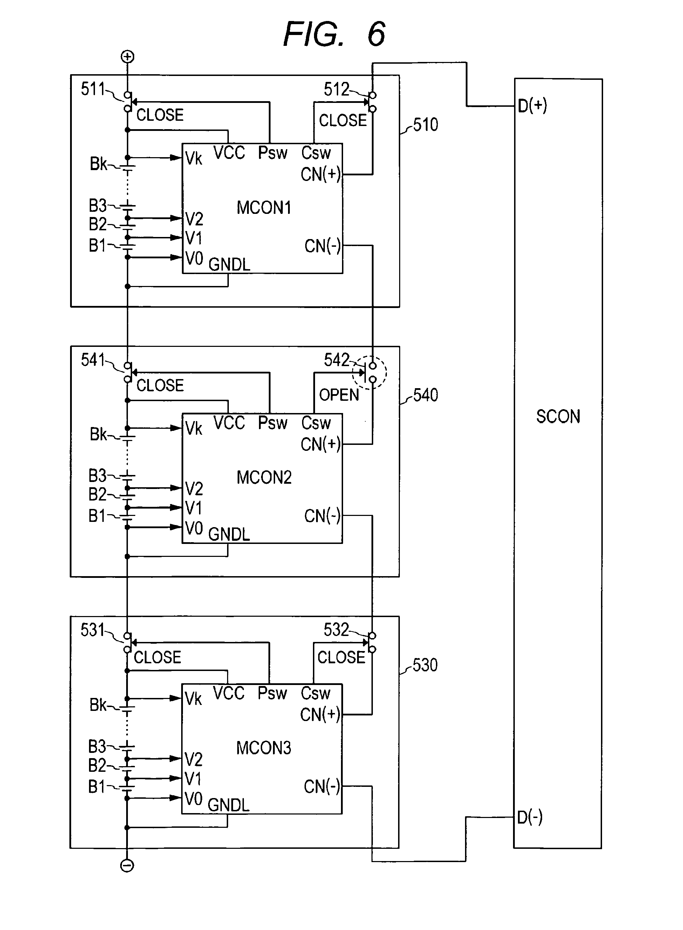

A flow in the case of performing information collection, deterioration determination, a replacement work of the storage battery module 300 will be explained using Figs. 4 to 6. Incidentally, the storage battery modules of Figs. 5, 6 are the same as the storage battery module shown in Fig. 3, but are shown with the notation simplified (for example, the monitor line is omitted). Moreover, the flow of Fig. 4 is applicable if the control unit SCON and the storage battery module have a capability of performing the mono-directional communication (D(+) → D(-)).

The control unit SCON collects information on a state of each storage battery module from the module controller MCON periodically (S01). The control unit SCON performs the deterioration determination on each storage battery module based on the acquired information (S02). Deterioration of the storage battery module is produced by repeating charge and discharge. The deterioration is determined by whether a reduction in capacity of the storage battery module (deterioration in capacity) or an increase in internal resistance thereof (deterioration in resistance) exceeds a predetermined threshold. For example, a module whose capacity at the time of full charge that is assumed from the collected information decreased to 70% of rated capacity (threshold) can be defined as the deteriorated module. Incidentally, since an amount of arithmetic processing of the deterioration determination is large and real time processing is not demanded severely, the control unit SCON is let to perform the deterioration determination of the module. In this example, let it be assumed that a module 520 (Fig. 5) is determined to be a deteriorated module.

The control unit SCON notifies a disconnect instruction to a module 530 that adjoins the deteriorated module 520 on its negative electrode side (S03). The adjacent module 530 sets a communication line switch 532 to OPEN, disconnecting the communication line (S04). Subsequently, the power source line is cut by setting a switch 531 to OPEN (S05). The control unit SCON transmits a test signal from the communication terminal D(+), and checks by timeout that this test signal does not return to the communication terminal D(-) through the communication line connected in the daisy chain. Thereby, the control unit SCON can check that the communication line has been cut. Thereby, the deteriorated module is disconnected from the module 530 that adjoins the negative electrode side thereof.

Next, the control unit SCON notifies the disconnect instruction to the deteriorated module 520 (S07). Although the daisy chain connection has been disconnected by the switch 532, the deteriorated module 520 can receive the instruction from the control unit SCON because the storage battery modules placed on the further positive electrode side than it are connected normally. Also for the deteriorated module 520, the communication line and the power source line are similarly disconnected in this order (S08, S09). Incidentally, Fig. 5 shows a connection state of the switch at Step S08. Through the above processes, the deteriorated module 520 will be in a state of being independent from the system, and will become replaceable by the user. Regarding disconnection completion of the deteriorated module 520, it may be configured that the deteriorated module 520 is determined to have completed disconnection by a fact that a sufficient time has elapsed after the control unit SCON instructed the disconnection. Moreover, an LED that turns on according to OPEN/CLOSE of the switch in the storage battery module may be provided, and thereby it may be configured so that the user may become able to judge OPEN/CLOSE of the switch of the storage battery module visually.

After that, the user removes the deteriorated module and replaces it with a new module 540 (S10). Re-connection of the module is carried out autonomously, for example, by detecting that both the positive electrode side power source terminal and the negative electrode side power source terminal are connected to another storage battery module. At this time, each module controller MCON controls so that the communication line switch is made to set CLOSE after a power source line switch is made to set CLOSE (S11 to S12, S14 to S15). Although an example of Fig. 4 is an example where the adjacent module performs the operation prior to other modules, either the adjacent module or the new module may performs it prior to the other module, or they may perform it simultaneously. Incidentally, Fig. 6 shows a connection state of the switch at Step S13. The module whose switch connection is completed outputs a connection completion signal to the control unit SCON (S13, S16). The control unit SCON ends the replacement of the storage battery module by receiving the connection completion signals from the both modules.

The above is an example in the case where the storage battery module exists also on the negative electrode side of the storage battery module to be replaced. In the case of the replacement of the storage battery module on the most negative electrode side (the case where no storage battery module exists on the negative electrode side thereof), the switch 105 (Fig. 1) is used to disconnect the communication line on the negative electrode side. The switch 105 is controlled by the control unit SCON.

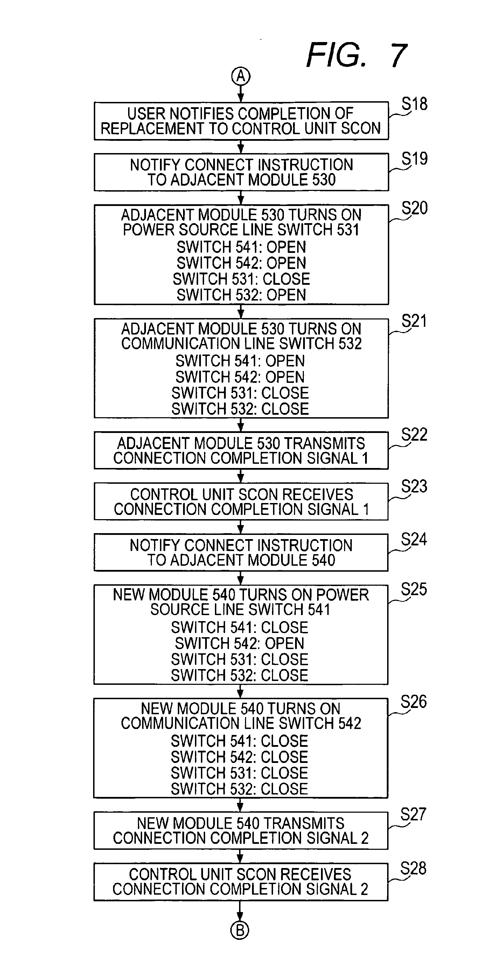

Incidentally, in the case where the storage battery system is configured so that the storage battery modules can establish the bidirectional communication between them, the connection flow of a new module can be set as shown in Fig. 7. A portion that is altered is steps between (A) and (B) of Fig. 4. After the replacement of the module, the user notifies the control unit SCON of completion of the module replacement. Upon reception of this notification, the control unit 200 instructs the module 530 that adjoins the negative electrode side of the new module 540 to start the connection. This instruction can be transmitted by the negative electrode side communication terminal D(-) communicating in the positive electrode direction. Upon reception of this instruction, the adjacent module 530 connects the power source line first (S20). After completion of the connection of the power source line, the communication line is connected (S21). The adjacent module 530 transmits the connection completion signal to the control unit SCON (S22). The connection completion signal is also transmitted to the control unit SCON from the adjacent module using the communication line on the negative electrode side. When the control unit SCON receives the connection completion signal (S23), the control unit SCON instructs the new module 540 to start the connection (S24). This instruction is also transmitted from the negative electrode side communication terminal D(-). Similarly, also in the new module 540, the power source line and the communication line are connected in this order (S25 and S26). When the control unit SCON receives an adjacent connection completion signal (S27 and S28), the replacement of the storage battery module is ended.

Thus, when the bidirectional communication is possible, autonomous switch control in the case of the replacement of the storage battery module becomes unnecessary. Moreover, it becomes also possible to make sure communication line disconnection (Step S06 of Fig. 3) by making the control unit SCON transmit a signal indicating disconnection completion.

Furthermore, an accompanying effect in the configuration of Fig. 3 is that since an internal switch is provided between an external element and the internal element, it is also possible to increase safety as a single body of the storage battery module if the storage battery module is configured so that these internal switches may be set OPEN when it is not in use.

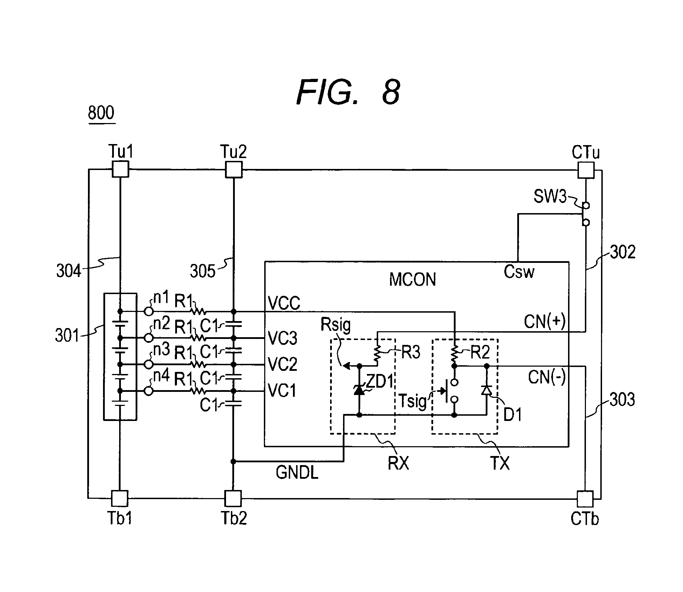

Fig. 8 shows a modification of the storage battery module shown in Fig. 3. This example is one such that the switches SW1, SW2 controlled by the power source control signal Psw are detached from the configuration of Fig. 3. As was already explained, what is necessary to realize the effect of the present invention is elimination of a state where the communication line is connected to the storage battery system with the power source line making a short circuit. Therefore, if the storage battery module is configured so that the switch SW3 may be controlled to be OPEN when the module is replaced, withstand voltage breakdown can be avoided even with the configuration of Fig. 8. That is, the storage battery module becomes replaceable by the battery module replacement flow (Fig. 4) from which the steps related to turning-off/turning-on of the power source line switch, i.e., Steps S05, S09, S11, and S14 are eliminated, or by the battery module re-connection flow (Fig. 7) from which the steps related to turning-on of the power source line switch, i.e., Steps S20 and S25 are eliminated. In this case, the switch is not connected in series to the power source line (namely, between electric cells), and therefore efficiency of the system improves.

In the foregoing, the modifications where the internal switch is provided in the storage battery module of the first embodiment were explained. Either of the modifications enables the module to be detached and re-connected surely after stabilizing the power source by controlling timings of OPEN/CLOSE of the internal switch, and therefore has an effect to increase the safety of the module, eventually of the system.

### Second Embodiment

A second embodiment will be described. The second embodiment is one that prevents the dielectric breakdown of the internal elements of the module by making structures of external terminals of the storage battery module different between the power source terminal and the communication terminal. In the second embodiment, the internal configuration of the storage battery module is a configuration corresponding to components 210 of Fig. 2.

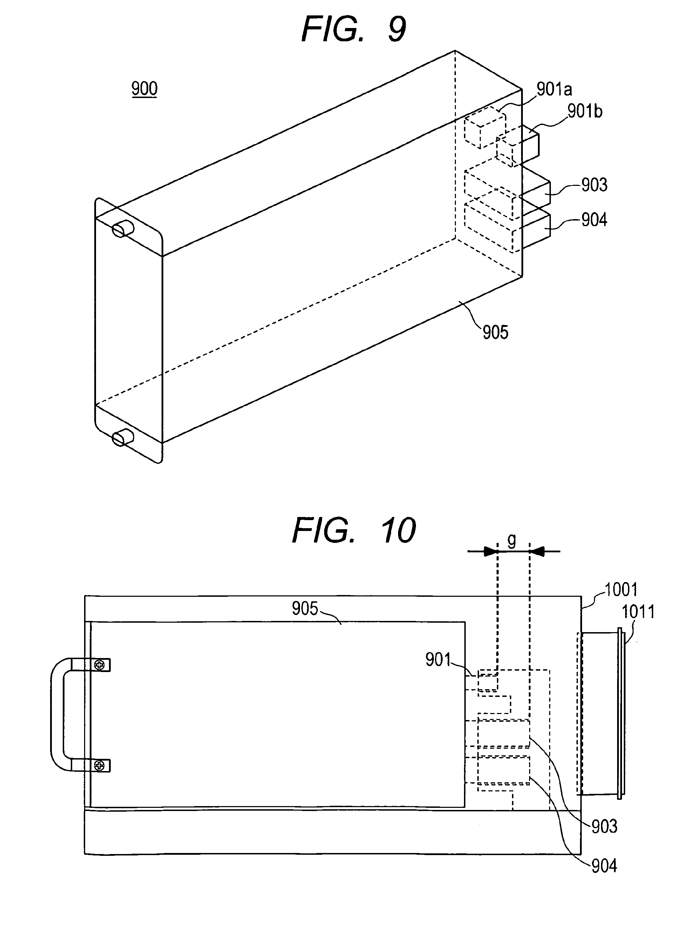

Figs. 9, 10 show an outside appearance and a sectional view of a storage battery module 900 according to the second embodiment, respectively. An enclosure 905 of the storage battery module is provided with a communication connector 901 and power source connectors (a positive electrode and a negative electrode) 903, 904 on its backside portion. If the module is a module that supports the bidirectional communication, the four communication connectors 901 will be provided. As shown in Fig. 10, a tip of the communication connector 901 is located at a shorter position than tips of the power source connectors 903, 904 by a length shown by an interval g. Because of a fact that the communication connector 901 is shorter than the power source connectors 903, 904, when the module is pulled out, the communication connector is disconnected first and the power source connectors are disconnected after that. Moreover, when inserting the storage battery module 900, the power source connectors are connected first and the communication connector is connected next; therefore, the same effect as the disconnection/connection flow shown in the first embodiment can be attained. What is necessary for the gap g is just to set it to about 1 mm to 50 mm. Incidentally, Fig. 10 shows a state where the storage battery module 900 is housed in a battery rack 1001 of the storage battery system, and a component 1011 is a cooling fan provided on a backside of the rack.

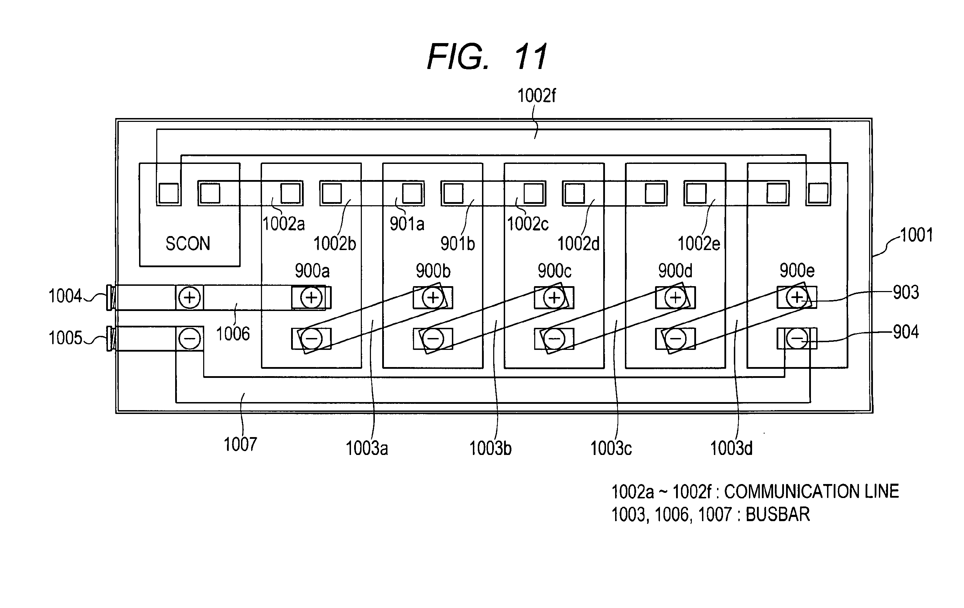

Fig. 11 shows a state where the storage battery module 900 is connected in the battery rack 1001. Specifically, the figure shows a state where the control unit SCON and the five storage battery modules 900 are connected. The communication terminals 901 of the storage battery modules 900 are connected in the form of the daisy chain with busbars 1002a to 1002f. Moreover, adjoining power source modules are connected by busbars 1003a to 1003d for power source extending in an oblique direction. Thereby, positions of the power source terminals of the power source modules 900 can be made common. Moreover, to a rack power source terminal (positive electrode) 1004, the positive electrode of the power source module 900a that is located on the most positive electrode side of the terminal 1004 is connected with a busbar 1006 for power source; to a power source terminal (negative electrode) 1005, the negative electrode of the power source module 900e that is located on the most negative electrode side of the terminal 1005 is connected with a busbar 1007 for power source. Incidentally, as was explained in Fig. 10, since the tips of the power source connectors for connecting with the busbar for power source are configured to protrude to the battery rack side ahead of the tips of the communication connectors for connecting with the busbar for communication, a positional relationship of the busbar 1002 for communication and the busbar 1003 for power source is set to a positional relationship that complies with positions of the connector of the module inserted into the battery rack.

## Claims

1. A storage battery system that has a plurality of storage battery modules connected in series, the system comprising:
a power source line for connecting power source terminals of the plurality of storage battery modules;
a communication line for connecting communication terminals of the plurality of storage battery modules; and
a mechanism of, when a first storage battery module is detached from the plurality of storage battery modules, disconnecting the power source line connected to the first storage battery module after disconnecting the communication line connected to the first storage battery module.

2. The storage battery system according to claim 1, comprising a mechanism of, when replacing the first storage module that was detached with a second storage battery module, connecting the communication line to the second storage battery module after connecting the power source line to the storage battery module.

3. The storage battery module according to claim 1,
wherein the storage battery module has a communication line switch between the communication line and a transmitter or receiver circuit, and
wherein, when the storage battery module is detached, the communication line switch is turned off.

4. The storage battery module according to claim 3,
wherein the storage battery module has a power source line switch between the power source line and an electric cell, and
wherein, when the first storage battery module is detached, the power source line switch is turned off after the communication line switch was turned off.

5. The storage battery system according to claim 2,
wherein the storage battery module has a communication line switch between the communication line and a transmitter or receiver circuit, and
wherein, when the first storage battery module is replaced with the second storage battery module, the power source line is connected to the second storage battery module in a state where the communication line switch is being turned off.

6. The storage battery system according to claim 5,
wherein the storage battery module has a power source line switch between the power source line and an electric cell, and
wherein, when the first storage battery module is replaced with the second storage battery module, the communication line switch is turned on after the power source line switch was turned on.

7. The storage battery system according to claim 1, comprising a battery rack that has a busbar for power source and a busbar for communication and is for connecting the storage battery modules one another,
wherein in each of the storage battery modules, tips of the power source connectors that are connected to the busbar for power source protrude to the battery rack side ahead of tips of the communication connectors that are connected to the busbar for communication.

8. The storage battery module according to claim 1, comprising a control unit for controlling the storage battery system,
wherein the control unit and the plurality of storage battery modules are connected one another in the form of a daisy chain with the communication line.

9. A storage battery module, comprising:
a plurality of electric cells connected in series;
a power source connector for connecting the electric cells and other storage battery modules;
a transmitter or receiver circuit;
a communication connector for connecting the transmitter or receiver circuit and a receiver or transmitter circuit of an other storage battery module; and
a first switch provided between the communication connector and the transmitter or receiver circuit.

10. The storage battery module according to claim 9, comprising a second switch provided between the power source connector and the transmitter or receiver circuit.

11. A storage battery module, comprising:
a plurality of electric cells connected in series;
a power source connector for connecting the electric cells and another storage battery module;
a transmitter or receiver circuit; and
a communication connector for connecting the transmitter or receiver circuit and a receiver or transmitter circuit of the other storage battery module,
wherein tips of the power source connectors protrude ahead of tips of the communication connectors.
